# EUROPEAN PATENT SPECIFICATION

(11) **EP 0 739 579 B1**
(45) Date of publication and mention of the grant of the patent: **26.08.1998**
(21) Application number: 95907168.9
(22) Date of filing: 12.01.1995
(51) Int. Cl.: H05K 3/32, H05K 3/34

(54) **A CIRCUIT BOARD WITH SPECIFICALLY DESIGNED CONNECTION TERMINALS**
LEITERPLATTE MIT SPEZIELL AUSGEFÜHRTEN ANSCHLUSSFLÄCHEN
PLAQUETTE DE CIRCUIT IMPRIME A BORNES DE RACCORDEMENT SPECIALES

(43) Date of publication of application: 30.10.1996
(73) Proprietor: XICON AB, 205 12 Malmö (SE)
(72) Inventor: WIKSTRÖM, Bo, S-261 75 Asmundtorp (SE)
(74) Representative: Petri, Stellan
(86) International application number: SE9500019
(87) International publication number: WO9519691

(56) References cited:
- ELEKTRONIKTIDNINGEN, Volume -, No. 16, October 1993, (Sweden), PER HENRICSSON, "Snart Aer Problemen med Limmade Komponenter Loesta", page 19 - page 20.

## Description

### Technical Field

The most frequently used method today of producing electrical circuits is to arrange circuit patterns of metal on a card or board of isolating material, usually a plastic material. Connection terminals are provided in the circuit pattern and are electrically connected with metallized contact surfaces of electrical components, so that the desired electrical function is obtained.

### Technical Background

In order to obtain the electrical connection, solder of varying metal composition with a larger or lesser amount of lead is usually utilized. At surface mounting of the electrical components a mechanical connection between the connection terminal and the contact surfaces of the component is also established by means of the solder. The solder provides good mechanical strength, as contact surfaces as well as connection terminals are made of metal.

The connection terminals are usually rectangular plates, which are shaped in accordance with the circuit pattern. Circular connection terminals can also be found.

It has become common to replace the solder by electrically conductive glue. Such glues have considerable advantages with regard to environmental conditions, above all because lead is obviated. Electrically conductive glues also fit well into a development of the present soldering technique in order to obtain a better quality in the electronic industry.

Most available glues have satisfactory electrical qualities and have good adhesiveness to the board of plastic. However, the glue acts differently at the application in comparison with the solder, and a problem which has appeared is that glue flows in under the surface mounting component. The component may herewith be short- circuited, so that the desired electrical function of the circuit is not obtained.

### The Invention

An object with the present invention is to substantially obviate the above mentioned problems and to bring about a short-circuit free connection between the connection terminals of the circuit board by means of electrically conductive glue. The connection shall also be mechanically stable.

These objects are fulfilled by the invention as defined in claim 1 in that the connection terminals are given such a form that glue is prevented from flowing from the connection terminal and spreading out under the surface mounting component, which is arranged between two adjacent connection terminals. The glue is instead allowed to flow in the opposite direction and spread out over the board, where the glue gets proper adhesion.

### Short Description of the Drawings

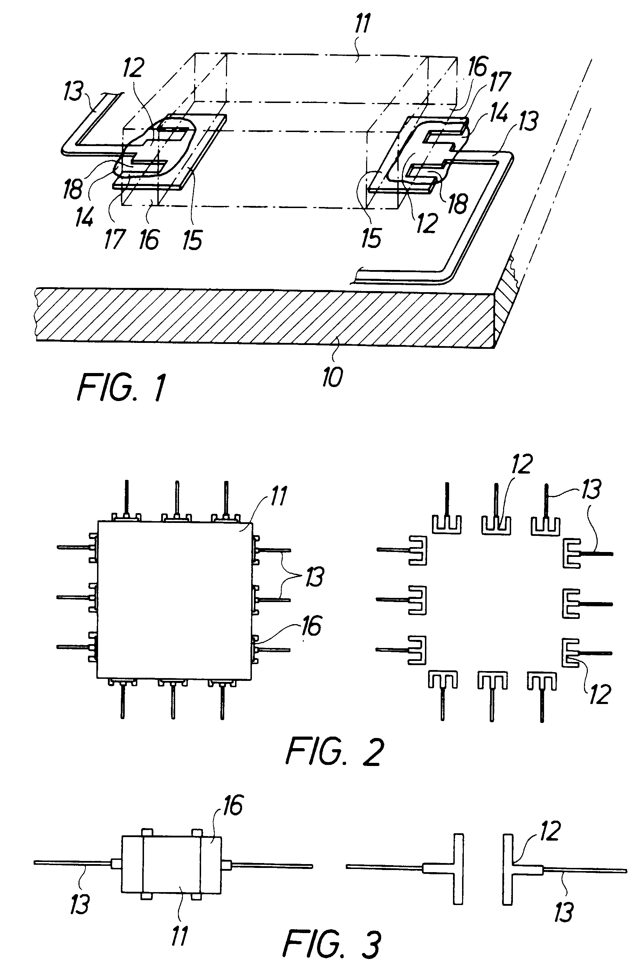

The invention will be further described below under reference to the attached drawings, in which Fig 1 is a diagrammatic perspective view of a portion of a circuit board with connection terminals according to an embodiment of the invention and Figs 2 - 6 are diagrammatic plan views of alternative shapes for the connection terminals according to embodiments of the invention, the left hand part of respective figure showing connection terminals without a component and the right hand part with a schematically shown component.

### Detailed Description of Preferred Embodiments

Fig 1 shows a conventional circuit board 10. In a conventional way the circuit board 10 is provided with circuits 13 of metal in a desired pattern. The circuits 13 are ended with connection terminals 12 according to an embodiment of the invention where electrical components shall be connected with the circuits in order for the desired circuit function to be obtained. In the shown example an electrical component 11 has been arranged between two connection terminals 12. In its ends the electrical component 11 is provided with metallized contact surfaces 16, which are electrically and mechanically connected with the connection terminals 12 by means of an electrically conductive glue 14.

Preferably the glue 14 is applied to the circuit board 10 on desired portions on beforehand by any suitable method, for example screen printing, coating, spraying etc. At the application of the glue 14 and/or when the glue is influenced, so that it flows in connection with the application of the component 11, the glue 14 shall be prevented from flowing in under the component and cause short circuiting and other malfunctions. This is according to the invention attained in that connection terminals 12, which are to be connected in pairs with each other by means of the component 11, are designed with continuous fronts 15 in its portions facing each other. The thickness of the connection terminals 12 and the circuits 13 is slightly exaggerated in Fig 1, but the elevation from the circuit board provided by the connection terminal 12 with the front 15 will guide the glue 14 in the direction away from the component 11. In the preferred embodiment according to Fig 1 the connection terminals 12 are further designed with side members 17, which are perpendicular to the front 15 and which prevent the glue 14 from flowing out sideways. There are free surfaces 18 of the circuit board 10 between the side members 17 and the front 15, against which the glue 14 strongly adheres.

Depending on the circumstances and the actual use, the contact surfaces 16 of the electrical components 11 can lie directly against the connection terminals 12 or be separated therefrom by means of a layer of glue 14.

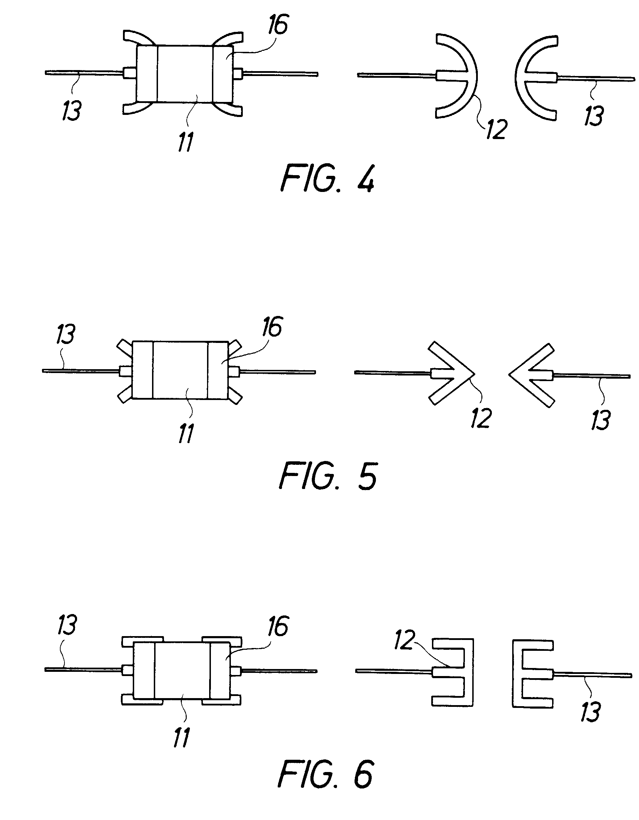

Figs 2 - 6 show alternative embodiments of connection terminals 12, which have properties directly corresponding to the connection terminals shown in Fig 1. In the embodiment according to Fig 5 side members 17 are lacking, which makes this embodiment less suitable in cases with several connection terminals arranged beside each other. Fig 6 shows an embodiment with a component having several contact surfaces. In such uses the connection terminals are grouped for conformity to the position for and the number of contact surfaces of the component.

The form and dimensions of the connection terminals 12 can be varied in many ways within the scope of the invention. Different materials can also be used for the circuit board, the circuits and the connection terminals. Electrically conductive glues of conventional kind are preferably used, but also anisotropic glues, i e glues conductive in only one direction, can be used in certain applications.

## Claims

1. A circuit board (10) with spaced circuits (13) and connection terminals (12) of metal for connection of electrical components (11) between the connection terminals by means of electrically conductive glue (14), which connects the connection terminals (12) and the components (11) electrically and mechanically, **characterized** in that the connection terminals (12) are designed in pairs with substantially continuous fronts (15) facing each other and in that a space (18), which is delimited behind each front (15) and is free from circuits (13) and connection terminals (12), is intended for receiving and adhering of the glue (14).

2. A circuit board according to claim 1, **characterized** in that the connection terminals (12) are designed with side members (17) extending from the fronts (15) for sideways delimiting the space (18).

3. A circuit board according to claim 1, **characterized** in that the connection terminals have the shape of an E.

4. A circuit board according to claim 1, **characterized** in that the connection terminals are arrow shaped.

## Patentansprüche

1. Leiterplatte (10) mit beabstandeten Leiterbahnen (13) und Verbindungsanschlüssen (12) aus Metall für den Anschluß elektrischer Bauelemente (11) zwischen den Verbindungsanschlüssen mit Hilfe elektrisch leitenden Klebstoffs (14), der die Verbindungsanschlüsse (12) und die Bauelemente (11) elektrisch und mechanisch miteinander verbindet, **dadurch gekennzeichnet,** daß die Verbindungsanschlüsse (12) paarweise mit im wesentlichen durchgehenden, einander gegenüberliegenden Frontabschnitten (15) ausgebildet sind, und daß ein Raum (18) hinter jedem Frontabschnitt (15) abgegrenzt und frei von Leiterbahnen (13) und Verbindungsanschlüssen (12) zur Aufnahme und zum Haften des Klebstoffs (14) vorgesehen ist.

2. Leiterplatte nach Anspruch 1, **dadurch gekennzeichnet**, daß die Verbindungsanschlüsse (12) mit Seitengliedern (17) ausgebildet sind, die sich von den Frontabschnitten (15) ausgehend erstrecken, um den Raum (18) in seitlicher Richtung zu begrenzen.

3. Leiterplatte nach Anspruch 1, **dadurch gekennzeichnet,** daß die Verbindungsanschlüsse die Form eines "E" aufweisen.

4. Leiterplatte nach Anspruch 1, **dadurch gekennzeichnet**, daß die Verbindungsanschlüsse pfeilförmig ausgestaltet sind.

## Revendications

1. Une plaquette à circuit imprimé (10) comportant des circuits très espacés et des bornes de connexion (12) en métal pour assurer la connexion de composants électriques (11) entre les bornes de connexion, au moyen d'une colle (14) conductrice de l'électricité, connectant, électriquement et mécaniquement, les bornes de connexion (12) et les composants (11), caractérisée en ce que les bornes de connexion (12) sont conçues par paires, avec des faces avant (15) sensiblement continues tournées les unes vers les autres, et en ce qu'un espace (18) qui est délimité derrière chaque face avant (15) et est exempt de circuit (13) et de bornes de connexion (12), est destiné à recevoir et assurer la mise en adhérence de la colle (14).

2. Une plaquette à circuit imprimé selon la revendication 1, caractérisée en ce que les bornes de connexion (12) sont conçues avec des organes latéraux (17) qui s'étendent depuis les faces avant (15) pour délimiter latéralement l'espace (18).

3. Une plaquette à circuit imprimé selon la revendication 1, caractérisée en ce que les bornes de connexion ont la forme d'un E.

4. Une plaquette à circuit imprimé selon la revendication 1, caractérisée en ce que les bornes de connexion sont en forme de flèches.
